(19) **Europäisches Patentamt**

**European Patent Office**

**Office européen des brevets**

(11) **EP 0 734 591 B1**

(12) **EUROPÄISCHE PATENTSCHRIFT**

(45) Veröffentlichungstag und Bekanntmachung des Hinweises auf die Patenterteilung:
**15.03.2000 Patentblatt 2000/11**

(51) Int. Cl.[7]: **H01L 31/068**, H01L 31/18, C30B 15/00

(21) Anmeldenummer: **95902765.7**

(22) Anmeldetag: **14.12.1994**

(86) Internationale Anmeldenummer:
**PCT/DE94/01489**

(87) Internationale Veröffentlichungsnummer:
**WO 95/17016 (22.06.1995 Gazette 1995/26)**

(54) **Solarzelle aus einer neuartigen Siliziumhalbleiterscheibe und Verfahren zur Herstellung der Siliziumhalbleiterscheibe**

Solar cell with a new type of silicon semiconductor plate and process for producing the silicon semiconductor plate

Cellule solaire comportant une plaquette semiconductrice en silicium d'un type nouveau et procédé de fabrication de la plaquette semiconductrice de silicium

(84) Benannte Vertragsstaaten:
**DE ES FR GB IT NL**

(30) Priorität: **17.12.1993 DE 4343296**

(43) Veröffentlichungstag der Anmeldung:
**02.10.1996 Patentblatt 1996/40**

(73) Patentinhaber:
**Siemens Solar GmbH**
**80807 München (DE)**

(72) Erfinder:
• **ENDRÖS, Arthur**
**D-80337 München (DE)**
• **MARTINELLI, Giuliano**
**I-44 100 Ferrara (IT)**

(74) Vertreter:
**Zangs, Rainer E., Dipl.-Ing. et al**
**Hoffmann Eitle,**
**Patent- und Rechtsanwälte,**
**Arabellastrasse 4**
**81925 München (DE)**

(56) Entgegenhaltungen:
• **APPLIED PHYSICS LETTERS., Bd.62, Nr.25, 21. Juni 1993, NEW YORK US Seiten 3262 - 3263 G. MARTINELLI ET AL. 'Growth of stable dislocation-free 3-grain silicon ingots for thinner slicing'**
• **23RD IEEE PHOTOVOLTAIC SPECIALISTS CONFERENCE, 10. Mai 1993, LOUISVILLE, USA Seiten 172 - 177 D.S. RUBY ET AL. 'Simplified processing for 23% efficient silicon concentrator solar cells'**
• **10TH E.C. PHOTOVOLTAIC SOLAR ENERGY CONFERENCE, 8. April 1991, LISBON, PORTUGAL Seiten 250 - 253 M.A. GREEN ET AL. 'Recent aqdavnces in silicon solar cell performance' in der Anmeldung erwähnt**
• **JOURNAL OF THE ELECTROCHEMICAL SOCIETY, Bd.110, Nr.1, Januar 1963, MANCHESTER, NEW HAMPSHIRE US Seiten 52 - 56 H.J. QUEISSER 'Properties of twin boundaries in silicon'**
• **SOLAR CELLS., Bd.31, Nr.3, Juni 1991, LAUSANNE CH Seiten 217 - 222 D. PALMERI ET AL. 'A reverse silicon solar cell'**
• **12TH EUROPEAN PHOTOVOLTAIC SOLAR ENERGY CONFERENCE, 11. April 1994, AMSTERDAM, NIEDERLANDE Seiten 1804 - 1806 A. BENATI ET AL. 'Evaluation of very thin crystalline silicon solar cells for large scale application'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Zur photovoltaischen Energieerzeugung im Leistungsbereich sind hocheffiziente, kostengünstige, großflächige und langzeitstabile Solarzellen aus umweltverträglichen und ausreichend vorrätigen Materialien erforderlich. Diese Forderungen werden gegenwärtig von keinem Solarzellentyp gleichzeitig erfüllt. Den Forderungen kommen zur Zeit einkristalline Silizium-Solarzellen (c-Si) am nächsten, die bis auf die Kostengünstigkeit bereits alle anderen Bedingungen erfüllen.

Das Erreichen hoher Wirkungsgrade (>20%) erfordert neben einer guten Oberflächenpassivierung (Oberflächenrekombinationsgeschwindigkeit $S_r$<100cm/s für die Rückseite und $S_f$<1000cm/s für die Front- oder Emitterseite) den Einsatz von Siliziumkristallen, deren Diffusionslänge L der Minoritätsladungsträger etwa dreimal höher ist als die Dicke d der verwendeten Ausgangswafer. Die derzeit eingesetzten, 〈100〉orientierten c-Si Wafer benötigen aus Gründen der mechanischen Stabilität aber noch eine Dicke von über 300μm. Die für 20% Wirkungsgrad notwendigen Diffusionslängen von ca. 900μm lassen sich daher nur durch den Einsatz von hochreinen, sauerstoff- und kohlenstoffarmen und damit sehr teuren Kristallen erzielen.

Die optimale physikalische Dicke von c-Si Solarzellen liegt allerdings nicht bei den derzeit verwendeten 300μm, sondern zwischen 60μm und 90μm. Dies liegt daran, daß mit abnehmender Dicke d einerseits die Leerlaufspannung $U_{SC}$ von Solarzellen steigt, während andererseits erst eine Silizium-Schichtdicke von ca. 100μm hinreichend ist, um das nutzbare Sonnenlicht (AM1.5) vollständig zu absorbieren und in Strom umzuwandeln. Eine Zellendicke d von etwa 60μm-90μm bedingt zudem einen wesentlich geringeren Materialbedarf. Durch die geringere Anforderung an die Diffusionslänge (180μm-270μm) wären auch die Anforderungen an die Materialqualität geringer, so daß auch preiswertes tiegelgezogenes Material (Cz-Si) als Ausgangsmaterial für hocheffiziente Silizium-Solarzellen eingesetzt werden könnte.

Die derzeit als Ausgangsmaterial hauptsächlich verwendeten Si-Einkristalle sind 〈100〉orientiert und lassen sich nur unter sehr hohen Säge- und Ausbeuteverlusten zu 60μm-90μm dikken Solarzellen verarbeiten. Daher ist auf dieser Basis eine wirtschaftliche Produktion nicht möglich.

Ein Lösungsweg, um zu hinreichend dünnen aber bruchtesten Absorbern zu kommen, wird mit polykristallinen Silizium-Dünnschichtsolarzellen auf Fremdsubstraten beschritten. Die Kostengünstigkeit, großflächige Erzeugbarkeit und Leistungsfähigkeit dieser Verfahren wurde aber noch nicht gezeigt.

Aufgabe der vorliegenden Erfindung ist es, eine Solarzelle aus kristallinem Silizium anzugeben, die in kosten- und materialsparender Weise einen hohen Wirkungsgrad von 20 Prozent und mehr aufweist.

Diese Aufgabe wird erfindungsgemäß mit einer Solarzelle nach Anspruch 1 gelöst.

Weitere Ausgestaltungen der Erfindung sowie ein Verfahren zur Herstellung der als Substrat verwendeten Siliziumhalbleiterscheiben sind weiteren Ansprüchen zu entnehmen.

Zur Lösung des Problems wird also ein Trikristall vorgeschlagen der bei gleichbleibenden elektronischen Eigenschaften eine wesentlich erhöhte mechanische Stabilität gegenüber den herkömmlichen Einkristallen aufweist, so daß freitragende erfindungsgemäße Siliziumhalbleiterscheiben (Tri-Kristall-Wafer) mit 60μm-90μm Dicke noch mit einer sehr hohen Ausbeute von über 95% gesägt und zu Solarzellen weiter verarbeitet werden können. Von vergleichbar dünnen herkömmlichen monokristallinen Wafern überstand kein einziger den Fertigungsprozeß.

Der grundlegende Vorteil des erfindungsgemäßen Trikristalls bzw. der daraus hergestellten Siliziumhalbleiterscheibe besteht darin, daß eine Kristallstruktur gezüchtet wird, die keinerlei schräg durch den Kristall laufende 〈111〉Ebenen enthält, längs denen ein Siliziumkristall beim Kristallziehen üblicherweise zuerst versetzt und dann bricht. Die Grenzflächen der monokristallinen Bereiche bilden miteinander Winkel kleiner 180°, so daß eine gerade durchlaufende Bruchbildung praktisch nicht möglich und eine Bruchbildung entlang der gewinkelten Grenzflächen erschwert ist.

Dies wird dadurch erreicht, daß eine Kristallstruktur erzeugt wird, bei der die 〈111〉Ebenen die Einhüllenden des Kristalls darstellen und somit exakt senkrecht zur Oberfläche der Siliziumhalbleiterscheibe verlaufen. Treten nun Zugkräfte längs der Oberfläche auf, die senkrecht auf einer 〈111〉Ebene stehen, so entstehen bei dieser Anordnung keinerlei Komponenten dieser Kraft parallel zu den 〈111〉Ebenen, so daß eine Versetzungsbildung und ein anschließender Bruch unterdrückt wird. Treten andererseits Zugkräfte auf, die parallel zu einer 〈111〉Ebene verlaufen, so wird die Versetzungsbewegung im Trikristall dadurch unterdrückt, daß die Trikristall-Wafer wegen der Verkippung der monokristallinen Bereiche keine gemeinsamen durchgängigen 〈111〉Ebenen beinhalten. Eine Versetzungsbewegung und der Bruch wird durch die verwinkelten Grenzflächen blockiert.

Der beschriebene Trikristall ist aus einem Artikel von G. Martinelli und R. Kibizov in Appl. Phys. Lett. 62 (25), 21 June 1993, Seiten 3262 bis 3263, bekannt. In dem Artikel wird die Möglichkeit beschrieben, Wafer mit einer Dicke von weniger als 200 μm aus dem Trikristall zu fertigen und diesen für photovoltaische Anwendungen zu verwenden.

Das Ziehen eines derartigen Trikristalls hat gegenüber der Züchtung von Einkristallen Kosten-, Qualitäts- und Geschwindigkeitsvorteile, die für die Photovoltaik von großer Bedeutung sind:

i.) Die Züchtung eines Trikristalls kann - bei gleichbleibender Materialqualität - um den Faktor 2-3 schneller erfolgen als die Züchtung eines ⟨100⟩Einkristalles.

ii.) Beim CZ-Ziehen kann ein Trikristall unmittelbar - ohne einen spitz zulaufenden Konus ziehen zu müssen - von der Schmelze abgezogen werden. Aufgrund der besonderen Geometrie laufen hier keine Versetzungen ins Material zurück wie beim Ziehen eines herkömmlichen Monokristallstabs (Material- und Zeitersparnis).

iii.)Die Abkühlzeit von Trikristallen kann aufgrund der besseren mechanischen Stabilität gegenüber Einkristallen von 3 Stunden auf 1 Stunde gesenkt werden, ohne daß der Stab versetzt oder springt (Zeitersparnis).

iv.) Ein wiederholtes Ziehen von mehreren Stäben aus der jeweils verbleibenden Restschmelze ist im Falle eines Einkristalles wegen Versetzungsbildung durch Verunreinigungseinbau nur etwa zweimal möglich - bei Trikristallen kann durch die hohe Versetzungsfestigkeit etwa zehnmal gezogen werden. Ein Quarztiegel läßt sich dadurch öfters benutzen, sofern das verbrauchte Siliziummaterial der Schmelze wieder zugeführt wird (Mehrfachnutzung des Tiegels, Zeitersparnis).

v.) Durch die Möglichkeit, den Kristall von der Schmelze abzuziehen (ii.), den Kristall schnell abzukühlen (iii.) und mehrere Tiegelfüllungen zu verwenden (iv.), läßt sich eine schnelle und quasikontinuierliche Züchtung erreichen. Diese ermöglicht insbesondere bei kurzen Tri-Kristall-Stäben eine sehr gute Gleichförmigkeit der Kristalleigenschaften über die Stablänge, da die Schmelze immer nur zum gleichen (geringen) Teil leergezogen wird.

Aufgrund der sehr guten mechanischen Festigkeit lassen sich Trikristallstäbe mit handelsüblichen Drahtsägen mit höchsten Ausbeuten auf die für Si-Solarzellen optimale Dicke von 60-90$\mu$m sägen. Diese Wafer sind mechanisch sehr stabil und können zu Solarzellen weiterverarbeitet werden.

Zur Herstellung von Solarzellen mit Wirkungsgraden >20% auf Basis eines 60$\mu$m-90$\mu$m dicken Trikristall-Wafers ist eine Diffusionslänge L der Minoritätsladungsträger von etwa 180$\mu$m-270$\mu$m notwendig. Diese Werte sind heute bereits mit kostengünstigem, tiegelgezogenen Silizium (z. B. CZ-Silizium) erreichbar, so daß eine Hochleistungszelle auch mit preiswertem Material herstellbar ist. Hierzu wird ein p-leitender Trikristallwafer (1-10 Ohm*cm, L>180$\mu$m) durch Eindiffusion von Phosphor einseitig mit einem 0,2-2$\mu$m tiefen Emitter versehen. Die Oberflächenkonzentration von Phosphor liegt dabei im Bereich von ca. 0,8-5*10$^{19}$cm$^{-3}$.

Um die Rekombination von Minoritätsladungsträgern an den Oberflächen zu verhindern, muß eine Passivierung der Front- sowie der Rückseite der Solarzelle erfolgen. Für Wirkungsgrade über 20% ist eine Passivierung der Frontseite auf Rekombinationsgeschwindigkeiten $S_f$<1000cm/s nötig, während die Rückseite auf $S_r$<100cm/s passiviert werden muß. Zur Frontseitenpassivierung kann ein Oxid verwendet werden, das die dem Licht ausgesetzte Oberfläche schützt. Eine Antireflexschicht aus z.B. Siliziumnitrid kann Reflexionsverluste vermeiden und den Wirkungsgrad der Solarzelle weiter verbessern. Die Rückseite kann entweder durch ein "back surface field", das durch eine Eindiffusion von Bor erzeugt wird, oder durch das Aufbringen eines Oxides passiviert werden.

Da durch die optimale Dicke der oberflächenpassivierten Trikristallwafer bereits eine vollständige Sammlung aller lichtgenerierten Minoritätsladungsträger auch bei preiswertem Ausgangsmaterial realisierbar ist, spielt die verwendete Bauform der Solarzelle nur noch eine untergeordnete Rolle, sofern die Abschattungs- und Reflexionsverluste kleiner als 8% gehalten werden und ein Füllfaktor von 80% erzielt wird. Solche Geometrien sind beispielsweise von R.A.Sinton, P.Verlinden, D.E.Kane und R.M.Swanson in Proc.of the 8.EC-PV-Solar Energy Conference, Florence, 1988, Kluwer Academic Publishers, p.1472ff.und von M.A.Green in Proc.of the 10.EC-PV-Energy Conference, Lisbon, 1991, Kluwer Academic Publishers, p.250ff.vorgeschlagen und bereits hergestellt worden.

Die Kontaktierung der Solarzelle erfolgt entweder durch Siebdruck einer Silberpaste durch eine Maske mit anschließendem Einbrennen oder durch Aufdampfen von Ti/Pd/Ag auf die Frontseite bzw. von Al auf die Rückseite der Zelle.

Wegen ihrer Kristallorientierung lassen sich die Trikristall-Wafer nicht mit einer Texturätze texturieren. Stattdessen kommt hier eine standardmäßige Vergütung der Solarzellenvorderseite durch das Aufbringen von Titanoxid zum Einsatz. Alternativ kann in einem preiswerten und schnellen Verfahren eine Textur der Solarzellenvorderseite mit inversen Kegeln erfolgen. Dazu wird ein gegen ein Siliziumätzmittel resistenter Lack auf der Frontseite des Wafers aufgebracht, gemäß einem regelmäßigen Lochmuster belichtet und entwickelt. Die in dem Lochmuster freigelegten Siliziumoberflächen werden schließlich mit einer oxidierenden sauren oder einer basischen Ätzlösung geätzt, wobei in der Waferoberfläche ein Lochmuster von inversen Kegeln erzeugt wird.

Im Folgenden wird die Erfindung anhand von Ausführungsbeispielen und der dazugehörigen 10 Figuren näher erläutert.

Dabei zeigen

die Figuren 1 bis 6 in schematischer Darstellung verschiedene Verfahrensstufen bei der Herstellung eines Trikristallstabs,

die Figur 7 eine erfindungsgemäße Siliziumhalbleiterscheibe in der Draufsicht und

die Figuren 8 bis 10 die Siliziumhalbleiterscheibe im schematischen Querschnitt während verschiedener Verfahrensstufen bei der Weiterverarbeitung zu einer Solarzelle.

**Herstellung des Impfkristalles zur Trikristallzüchtung:**

Figur 1:

a) Ein konventionell hergestellter und zum Beispiel Cz-gezogener 〈110〉orientierter Einkristall wird mit einer Diamant-Innenlochsäge, die sich in einem Goniometer befindet, mit 2° Genauigkeit so gesägt, daß sich ein Oktaeder H mit acht 〈111〉orientierten Oberflächen ausbildet.

b) Schritt a) wird zweimal wiederholt, um insgesamt drei Oktaeder herzustellen, die die Keimkristalle (H, T1, T2) für den Trikristall bilden sollen.

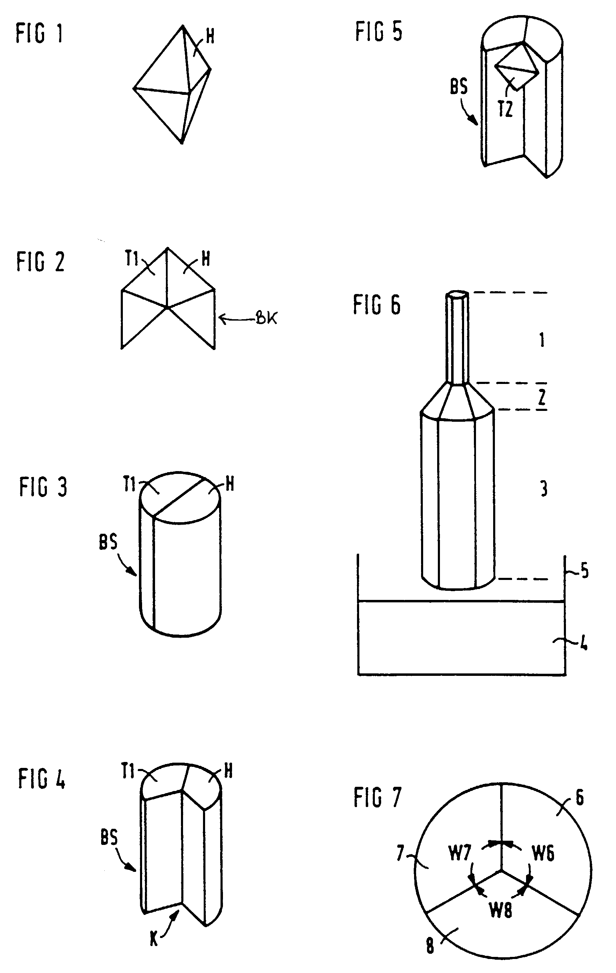

c) Zwei der Oktaeder H, T1 aus a) und b) werden mit einem Molybdän-Draht derart zusammengebunden, daß der erste Keimkristall (H) so mit dem zweiten Keimkristall (T1) in Verbindung kommt, daß sich eine Zwillingskorngrenze erster Ordnung ausbildet. Möglich ist es auch, die Keimkristalle H, T1 mit anderen Mitteln aneinander zu fixieren, vorausgesetzt, daß das Material des Fixierungsmittels gegenüber der Siliziumschmelze inert ist und einen höheren Schmelzpunkt als diese aufweist. Geeignet wäre daher beispielsweise auch ein Wolframdraht. In Figur 2 ist der so hergestellte Bikristallkeim BK in der Draufsicht dargestellt.

d) Aus dem Bikristallkeim BK wird nun mittels des Cz- oder floating zone Verfahrens (Fz)ein Bikristallstab BS von etwa 10cm Durchmesser und 10cm Länge gezüchtet (siehe Figur 3).

e) Mittels eines Goniometers und einer Diamantsäge wird aus dem Bikristallstab BS ein Keil K entfernt, um Platz für den dritten Keimkristall T2 zu schaffen. Hierzu werden Sägeschnitte längs der 〈112〉 und der 〈114〉 Richtung durchgeführt (siehe Figur 4) und in den zwei monokristallinen Bereichen (H,T1) jeweils eine 〈111〉Kristallebene freigelegt.

f) Der dritte Keimkristall T2 wird nun mit Mo-Draht so eingefügt, daß er mit dem Keimkristall H bzw. mit dem daraus gewachsenen Kristallbereich zusammen wieder eine Zwillingskorngrenze erster Ordnung bildet (siehe Figur 5).

g) Der Bikristallstab BS wird nun auf die Länge des dritten, Keimkristalls T2 zurückgesägt. Erhalten wird ein Trikristall-Impfling.

h) Mit Hilfe des Trikristall-Impflings von g) wird nun mittels des Cz- oder Fz-Verfahrens ein etwa 20 cm langer dünner Trikristallstab gezogen, der im Querschnitt nicht breiter als $(2{,}54 \text{ cm})^2$ $((1 \text{ inch})^2)$ ist.

**Züchtung von Trikristallen**

i) Der dünne Trikristallstab von h) wird als Impfkristall zur Trikristallzüchtung verwendet. Hierbei ist es entscheidend, daß zum einen der Impfkristall so orientiert wird, daß die "Nahtstelle" der drei Kristallite senkrecht orientiert ist. Zum anderen ist zu Beginn des Wachstums zu kontrollieren, ob sich an den Rändern des wachsenden Kristallstabs die sechs spiegelähnlichen Facetten befinden, die ein Beweis für das Entstehen des Trikristalls sind. Treten diese Facetten nicht auf, so ist erneut mit dem Wachstum zu beginnen.

Der Trikristall wächst beim Kristallziehprozeß mit einer Geschwindigkeit, die ca. 2-3 mal größer ist als die Wachstumsgeschwindigkeit herkömmlicher Monokristallstäbe aus Silizium. Dies ist auf die erhöhte Anzahl von 6 "Wachstumsflachen" des Trikristalls zurückzuführen.

Der Querschnitt des Trikristallstabs ist wie bei herkömmlichen Monokristallen abhängig von der Ziehgeschwindigkeit und kann auf einen gewünschten Wert von ca. 15,24-20,32 cm (6-8 inch) eingestellt werden. Der Trikristall wird bis zu einer beliebigen Länge gezogen, die ohne Zeit- oder Verfahrensnachteile wesentlich kürzer gewählt werden kann als beim herkömmlichen Ziehen von Monokristallen. In vorteilhafter Weise wird die Kristallstablänge von der Größe des verwendeten Siliziumschmelztiegels abhängig gemacht oder umgekehrt. Um ein zu starkes Ansteigen von Verunreinigungen mit wachsender Länge des Kristallstabs zu vermeiden, wird er so lange gezogen, bis die Siliziumschmelze im üblicherweise aus Quarz bestehenden Schmelztiegel um ein Drittel abgenommen hat.

k) Nach erfolgreicher Züchtung wird der Trikristall 3 schnell von der Schmelze 4 abgezogen und in 2cm Höhe darüber für einige Minuten stehengelassen, damit sich ein Temperaturgleichgewicht einstellen kann. Durch dieses Verfahren wird ein versetzungsfreier Trikristall erzeuge (Siehe dazu auch Figur 6).

Figur 6 zeigt den gezogenen Trikristall in schematischer Darstellung während der Phase des Abkühlens. Der Trikristall weist einen oberen Bereich 1 auf, welcher dem im Verfahrensschritt h) erzeugten dünnen Trikristallstab entspricht. Im mittleren Bereich 2 wächst der Trikristallstab schnell auf den gewünschten Durchmesser an. Dies kann wesentlich schneller als bei herkömmlichen Monokristallstäben erfolgen, da keine 〈111〉 Kristallebenen quer zur Ziehrichtung durch den Kristall verlaufen, entlang derer vorzugsweise Versetzungen erfolgen können.

Im unteren Bereich 3 weist der Trikristallstab bereits den gewünschten Querschnitt auf. Angedeutet sind drei der 6 Facetten, die sich zwischen den Schnittkanten der senkrecht stehenden 〈111〉 Kristallebenen gut erkennbar ausbilden. Ein wesentlicher Unterschied des Trikristallstab im Vergleich zu Monokristallstäben ist weiterhin, daß der Stab am unteren Ende gerade abschließt, da er schnell von der Schmelze 4 abgezogen werden kann. Bei Monokristallstäben muß dagegen noch ein Konus erzeugt werden, welcher später wieder verworfen wird und so zusätzliche Zeit und Aufwand erfordert.

**Quasi-kontinuierliche Trikristall-Zucht:**

l) Nach k) wird der Trikristall ganz hochgezogen, um in Schutzgasatmosphäre innerhalb etwa einer Stunde auf Raumtemperatur abgekühlt zu werden. Auch die Abkühlzeit von nur einer Stunde (gegenüber sonst erforderlichen 3 Stunden) bringt einen weiteren Zeit- und Kostenvorteil, da selbst bei dieser hohen Abkühlgeschwindigkeit im Trikristallstab keine Verspannungen auftreten, die zur Rißbildung oder sonstigen Beschädigung des Kristallstabs führen könnten.

m) Der nur zu etwa 1/3 leergezogene, heiße Quarztiegel 5 (Fassungsvermögen etwa 30kg) wird mit etwa 10kg Silizium nachgefüllt. Nach etwa einer Stunde ist das Silizium aufgeschmolzen und währenddessen auch der Kristallstab von l) abgekühlt.

n) Der dünne Impfkristall 1 wird vom Kristallstab 3 abgeschnitten und bei Schritt i) wieder eingesetzt.

Da der Tiegel nur zu 33% geleert wird, bleibt die Kristallqualität bezüglich des C-, O-, B- und P-Gehalts des Trikristallstabs sehr homogen über die Länge erhalten.

Mit dem erfindungsgemäßen Verfahren können bis ca. 10 Trikristallstäbe aus ein und dem selben Tiegel 5 gezogen werden, ohne daß der Tiegel zwischendurch entleert oder gar verworfen werden muß, wie es bei Monokristallstäben erforderlich ist. Auch die Qualität des 10. Trikristallstabs ist dann noch ausreichend, um daraus Wafer für Solarzellen mit hohem Wirkungsgrad herstellen zu können.

Aus dem so erzeugten Trikristallstab werden nun mit herkömmlichen Drahtsägen, insbesondere mit Multi-Wire-Sägen Wafer der gewünschten Dicke d herausgesägt. Es zeigt sich, daß die Wafer selbst bei einer Dicke von nur 60µm ohne allzu große Bruchgefahr mühelos gehandhabt werden können.

Unter Verwendung einer herkömmlichen Drahtsäge mit 300µm Drahtdurchmesser und daher 300µm Materialverlust pro Sägeschnitt erfordert das Heraussägen eines 60µm dicken Wafers aus dem Trikristallstab eine Stablänge von 360µm. Ein monokristalliner Wafer, der erst bei ca. 330µm Dicke handhabbar ist, erfordert dagegen eine Stablänge von 630µm. Bereits dabei ergibt sich mit dem dünnen Trikristallwafer eine Materialersparnis von ca. 40%.

Versuche haben gezeigt, daß der erfindungsgemäße Trikristallstab auch mit dünneren Drähten gesägt werden kann, so daß sich die Schnittverluste weiter reduzieren lassen. Bei bis zu 80µm dünnen Drähten läßt sich dabei eine Materialersparnis von bis zu 75% erzielen. Dies ergibt um den Faktor 4 verringerte Materialkosten pro Wafer.

Fig. 7 zeigt eine der erfindungsgemäßen Siliziumhalbleiterscheiben bzw. Trikristallwafer. Die drei monokristallinen Bereiche 6, 7 und 8, die auf die drei Keimkristalle H, T1 und T2 zurückgehen, sind kreissektorförmig und bilden mit- bzw. gegeneinander die Winkel W6, W7 und W8. Sofern die als Keimkristalle eingesetzte Oktaeder H, T1 und T2 exakt entlang der 〈111〉Ebenen herausgesägt wurden, sofern der Trikristallstab exakt vertikal mit sechs regelmäßigen Facetten gezogen wurde, und die Wafer senkrecht zur Stabachse herausgesägt wurden, beträgt der Winkel W6 exakt 109,47°. Bei gleichmäßigem Wachstum sind dann die beiden anderen Winkel W7 und W8 exakt gleich groß und betragen daher 125,26°. Unter den genannten Zucht- und Sägevoraussetzungen haben im Wafer alle drei monokristallinen Bereiche 6, 7 und 8 eine 〈110〉Oberfläche, oder genauer ausgedrückt eine 〈110〉(6), eine 〈$\overline{1}0\overline{1}$〉(7), bzw. eine 〈$\overline{1}\overline{1}0$〉Oberfläche (8). Möglich ist es natürlich auch, die Wafer mit nicht vertikal zur Stabachse gesetzten Sägeschnitten herauszusägen, wobei dann die Waferoberfläche von anderen Kristallebenen gebildet werden kann und entsprechend ellipsoid geformt ist.

Es wurde gefunden, daß die Einhaltung von vier Randbedingungen ausreichend ist, um eine Solarzelle mit einem Wirkungsgrad von 20% herzustellen. Dies sind wie bereits erwähnt die Diffusionslänge L der Minoritätsladungsträger und die Rekombinationsge-

schwindigkeiten $S_f$ und $S_r$ der Front- bzw. Rückseite. Außerdem ist bei Aufbringen der Frontkontakte und der Frontseitenvergütung bzw. -Passivierung darauf zu achten, daß die Abschattungs- und Reflexionsverluste unter 8% bleiben, was bereits mit herkömmlichen Verfahren erreicht wird. Zum Einhalten der ersten Bedingungen $L \geq 3d$ mit d = Waferdicke sind mit den erfindungsgemäßen Trikristallwafern bei Schichtdicken von d = 60 bis 70 μm Diffusionslängen von $L \geq 210$μm erforderlich. Diese Materialqualität kann mit herkömmlichem Czochralski-gezogenen Standardsiliziummaterial (CZ-Si) zur Verfügung gestellt werden. Bei monokristallinen Wafern mit d = 300μm muß $L \geq 900$μm erfüllt sein. Diese Qualität wird nur mit einem Siliziummaterial erhalten, das aus einem Floating-Zone Verfahren erhalten wird (FZ-Si). Dabei ist der Preis von FZ-Si um mehr als eine Größenordnung höher als der von CZ-Si. Die Randbedingungen $S_f \leq 1000$ cm/s und $S_r \leq 100$ cm/s können mit herkömmlichen Oberflächenvergütungen erzielt werden. Die Frontseite kann dazu mit einem Oxid passiviert werden. Für die Rückseite kann entweder ebenfalls ein Passivierungsoxid verwendet werden, oder ein Back-Surface-Field durch Eindotieren von Bor erzeugt werden.

Eine weitere Randbedingung, die jedoch größtenteils von den bereits genannten Randbedingungen abhängig ist, betrifft den Fülltaktor FF, der nicht unter 80% liegen sollte. Auch dieses ist mit bekannten und erprobten Verfahren erreichbar.

Da mit den erfindungsgemäßen Tri-Kristallwafern wegen deren unterschiedlicher Kristallgeometrie keine alkalische Texturätzung möglich ist, wird erfindungsgemäß eine daran angepaßte Oberflächenvergütung zur Verbesserung der Lichteinfallsgeometrie vorgeschlagen. Dazu wird ein Lochmuster von inversen Kegeln mittels einer diesem Muster entsprechenden Photolackmaske in die Waferoberfläche eingeätzt.

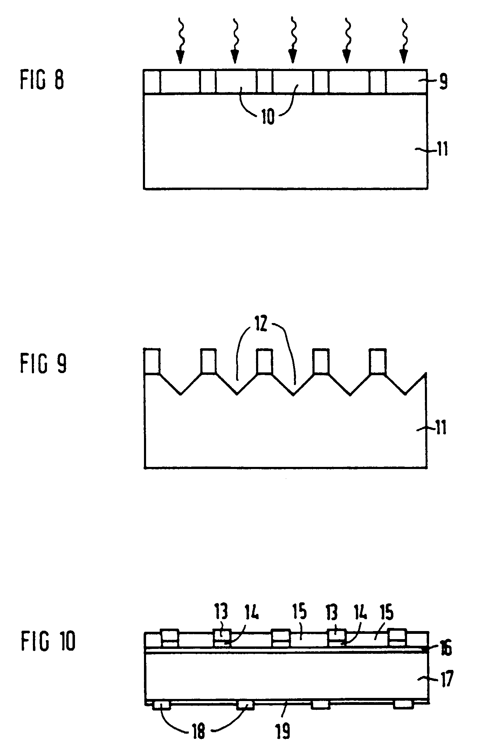

Figur 8: Durch ganzflächigen Siebdruck eines lichtempfindlichen und zum Beispiel positiv arbeitenden und druckbaren Polymers 9 auf die Frontseite des Trikristall-Wafers 11 und Ausbacken des Polymers 9 bei 150°C für ca. 10s wird eine ganzflächige Schutzschicht erzeugt.

Durch eine Lochmaske mit vorgegebenem Raster von Löchern mit je ca. 3-5μm Durchmesser wird die Polymerschicht 9 mit UV-Licht beleuchtet, um in den bestrahlten Bereichen 10 des Polymers 9 durch photochemische Erzeugung polarer Gruppen eine erhöhte Löslichkeit des Polymers zu bewirken.

Figur 9: Die belichtete Polymerschicht 9 kann nun durch naßchemisches Ätzen, zum Beispiel mit einem Gemisch aus Salpeter-, Fluß- und Essigsäure entfernt werden. An diesen ungeschützten Stellen 10 beginnt nun gleichzeitig ein Abätzen des darunter liegenden Siliziums. Nach ca. 10 Sekunden bilden sich inverse Kegel 12 in der Siliziumoberfläche 11 aus, die als Lichtfallen dienen.

Durch Ablösen der Photoresistschicht 9 mit Aceton oder anderen Lösungsmitteln wird die nun mit inversen Kegeln (Vertiefungen) versehene Waferoberfläche 11 wieder freigelegt.

Eine weitere Strukturvariante, die speziell auf die erfindungsgemäßen Trikristallwafer bzw. die daraus herstellbaren Hochleistungssolarzellen zugeschnitten ist, betrifft die Anordnung der Frontkontakte.

Figur 10: Es wird vorgeschlagen, die Frontkontakte 13 auf mesa-artig über die restliche Waferoberfläche erhabenen $n^{++}$-dotierten Halbleiterstrukturen aufzubringen, während die übrige Oberfläche der Frontseite vom $n^+$-dotierten Emitter 16 gebildet wird. Zur Herstellung dieser Struktur kann z.B. der Emitter tiefer als üblich durch Eindiffusion von Phosphor erzeugt werden, beispielsweise bis zu einer Tiefe von 1μm. In einem weiteren Dotierungsschritt wird in der Waferoberfläche eine flache und z.B. 0,4-0,8μm tiefe $n^{++}$-Dotierung ganzflächig in die Waferoberfläche eingetrieben. Zur Definition der Mesastrukturen 14 kann eine Photolacktechnik verwendet werden, wobei mit Hilfe einer Photolackmaske geätzt wird und der $n^{++}$-dotierte Bereich bis auf die mit der Photolackmaske abgedeckten Mesastrukturen 14 herausgeätzt wird. Über den Mesastrukturen 14 wird dann der Frontkontakt 13 aufgebracht. Möglich ist es auch, Mesastrukturen 14 samt dem Frontkontakt 13 selbstjustierend aufzubringen. Dazu wird zunächst der Frontkontakt 13 über der $n^{++}$-Dotierung aufgebracht und ein nachfolgender Ätzschritt mit dem gegebenenfalls geschützten Frontkontakt 13 als Ätzmaske durchgeführt.

Nach der Herstellung der Kontakte kann die Passivierungsschicht 15 aufgebracht werden, welche z.B. ein aufgewachsenes Oxid sein kann.

Die Reihenfolge und Art der Schritte ist für die Herstellung einer Hochleistungssolarzelle mit mindestens 20% Wirkungsgrad jedoch nicht entscheidend, sofern die oben genannten Randbedingungen eingehalten werden. Auch die Form der Kontakte auf Front- und Rückseite ist nicht von Bedeutung, wenn die gesamten Abschattungs und Reflexionsverluste unter 8% bleiben. So können beide Kontakte als Punktkontakt oder als Gridkontakt ausgebildet sein und der Rückkontakt zusätzlich als ganzflächige Elektrode ausgeführt sein. In der Figur 10 ist der Rückkontakt 18 als aufgedruckte und eingebrannte Al- oder Ag-Siebdruckpaste über einer Passivierungsschicht 19 ausgeführt. Möglich ist es auch, unter der Passivierungsschicht 19 durch Eindiffusion von Bor zusätzlich ein back-surface-field zu erzeugen, um die Minoritätsladungsträger (Elektronen) von einer Diffusion zur Oberfläche abzuhalten, wo die Rekombinationsgeschwindigkeit wegen der freien dangling bonds erhöht ist.

Ein weiterer Vorteil der erfindungsgemäß aus Trikristallwafern gefertigten Solarzellen liegt in deren erhöhter Leerlaufspannung, die wiederum den Füllfaktor und damit auch den Wirkungsgrad erhöht.

Somit können leistungsstärkere Solarzellen bei wesentlich erniedrigten Kosten mit konventionellen und erprobten Verfahren hergestellt werden.

**Patentansprüche**

1.  Solarzelle, aufgebaut auf einer mechanisch stabilen 60 bis 90 μm dicken Siliziumhalbleiterscheibe als Substrat, welche aus drei gegeneinander verkippten monokristallinen Bereichen (6, 7,8) besteht, die drei Kreissektoren bilden, deren Grenzflächen und -linien gegeneinander radial verlaufen und Winkel (W6, W7, W8) kleiner 180° miteinander bilden, wobei zwei der Grenzflächen Zwillingskorngrenzen erster Ordnung zwischen jeweils zwei ⟨111⟩Kristallebenen sind, mit

    -   einer leichten p-Dotierung in der Scheibe (11),

    -   einem flachen, 0,2-2μm tiefen $n^+$ dotierten Emitter (16) auf einer Frontseite

    -   einer ersten Passivierungsschicht (15) auf der Frontseite,

    -   einer zweiten Passivierungsschicht (19) oder einem back surface field auf der Rückseite und

    -   stromableitenden Kontakten (13, 18) auf Front- und Rückseite.

2.  Solarzelle nach Anspruch 1,
    dadurch gekennzeichnet, daß das Silizium tiegelgezogenes Silizium (Cz-Si), wobei der Wirkungsgrad der Solarzelle mehr als 20 Prozent ist.

3.  Solarzelle nach Anspruch 1 oder 2, bei der die Grenzflächen annähernd senkrecht zur Scheibenebene stehen und gegeneinander die Winkel W6, W7 und W8 bilden, wobei gilt:

    W7 = W8 = (360° - W6)/2 und W6 = 109,47 ± 2°.

4.  Solarzelle nach einem der Ansprüche 1 bis3, bei der die Oberflächen der drei monokristallinen Bereiche (6,7,8) ⟨110⟩Kristallebenen sind.

5.  Solarzelle nach einem der Ansprüche 1 bis 4, welche auf der Frontseite eine Texturierung in Form von in die Halbleiteroberfläche geätzten Kegeln (12) besitzt.

6.  Solarzelle nach einem der Ansprüche 1 bis 5, bei der die erste Passivierungsschicht (15) auf der Frontseite eine Oxidschicht ist, die eine Ladungsträgerrekombinationsgeschwindigkeit $S_r$ auf der Oberfläche von weniger als 1000 cm/s ergibt.

7.  Solarzelle nach einem der Ansprüche 1 bis 6, bei der die Rückseite eine Ladungsträgerrekombinationsgeschwindigkeit $S_r$ von weniger als 100 cm/s besitzt.

8.  Verfahren zum Erzeugen einer Siliziumhalbleiterscheibe für ein Solarzellensubstrat mit drei gegeneinander verkippten, Kreissektor förmigen monokristallinen Bereichen (6,7,8) mit den Schritten

    -   Herstellen von drei oktaederförmigen Keinkristallen (H,T1,T2) durch Heraussagen aus einem konventionellen ⟨110⟩orientierten Einkristall derart, daß sämtliche Oktaederflächen mit ⟨111⟩Kristallebenen identisch sind,

    -   Verbinden zweier der Keimkristalle (H,T1) durch Aufeinanderlegen und Fixieren mir einem Draht so, daß sich eine Zwillingskorngrenze erster Ordnung ausbildet

    -   mit Hilfe der beiden verbundenen Keimkristalle (H,T1) wird mittels eines Kristallzüchtungsverfahrens ein Bikristall (BS) gezüchtet

    -   aus dem Bikristall (BS) wird ein keilförmiges Stück (K) herausgesägt und dabei von beiden Halbkristallen jeweils eine ⟨111⟩Ebene freigelegt

    -   der dritte Keimkristall (T2) wird in den keilförmigen Spalt so eingefügt, daß er mit der ⟨111⟩ Kristallfläche eine zweite Zwillingskorngrenze erster Ordnung ausbildet

    -   der Bikristall (BS) wird ungefähr auf die Länge des dritten Keimkristalls (T2) zu einem Trikristall-Impfling verkürzt

    -   mit Hilfe des Trikristall-Impflings wird mittels eines Kristallzüchtungsverfahrens ein Trikristallstab aus einer Siliziumschmelze (4) gezogen

    -   aus dem Trikristallstab werden mit einer Drahtsäge Halbleiterscheiben herausgesägt.

9.  Verfahren nach Anspruch 8,
    bei dem zum Fixieren der Keimkristalle (H,T1,T2) ein Molybdändraht verwendet wird.

10. Verfahren nach Anspruch 8 oder 9,
    bei dem zum Kristallzüchten ein Czochralski Verfahren eingesetzt wird.

11. Verfahren nach einem der Ansprüche 8 bis 10, bei dem der Trikristall-Impfling und der wachsende Trikristallstab so ausgerichtet werden, daß sich sechs spiegelähnliche Facetten auf dem Trikristallstab ausbilden.

**12.** Verfahren nach einem der Ansprüche 8 bis 11, bei dem nach dem Ziehen eines ersten Trikristallstabs aus einem Quarzschmelztiegel die maximal zu einem Drittel verbrauchte Siliziumschmelze durch Zugabe frischen Siliziums nachgefüllt wird und der gesamte Vorgang bis zu zehn mal wiederholt wird.

**13.** Verfahren nach Anspruch 12,
bei dem als Keimkristall die abgesägte Spitze eines vorher gezogenen Trikristallstabs verwendet wird.

**Claims**

**1.** Solar cell, constructed on a mechanically stable, 60 to 90 μm thick silicon semiconductor wafer as a substrate, which comprises three monocrystalline regions (6,7,8), tilted towards one another and forming three sectors of a circle, the boundary surfaces and lines of which sectors run radially towards one another and enclose angles (W6, W7, W8) with one another which are smaller than 180°, two of the boundary surfaces being twin crystal boundaries of the first order between respectively two ⟨111⟩crystal planes, having

- a slight p-doping in the wafer (11)
- a flat, 0.2 - 2 μm deep $n^+$-doped emitter (16) on a front side,
- a first passivation layer (15) on the front side,
- a second passivation layer (19) or a back surface field on the rear side and
- current-diverting contacts (13, 18) on the front and rear side.

**2.** Solar cell according to claim 1,
characterised in that the silicon is crucible-pulled silicon (Cz-Si), the efficiency of the solar cell being more than 20 percent.

**3.** Solar cell according to claim 1 or 2, wherein the boundary surfaces lie approximately vertical to the plane of the wafer and enclose with one another the angles W6, W7 and W8, the following being valid:

W7 = W8 = (360° - W6)/2 and W6 = 109.47 ± 2°.

**4.** Solar cell according to one of claims 1 to 3, wherein the surfaces of the three monocrystalline regions (6,7,8) are ⟨110⟩crystal planes.

**5.** Solar cell according to one of claims 1 to 4, which has on the front side a texturing in the form of cones (12) etched into the semiconductor surface.

**6.** Solar cell according to one of claims 1 to 5, wherein the first passivation layer (15) is an oxide layer on the front side and produces a charge carrier recombination velocity $S_r$ on the surface of less than 1000 cm/s.

**7.** Solar cell according to one of claims 1 to 6, wherein the rear side has a charge recombination velocity $S_r$ of less than 100 cm/s.

**8.** Method of producing a silicon semiconductor wafer for a solar cell substrate with three monocrystalline regions (6,7,8), in the form of sectors of a circle and tilted towards one another, with the steps:

- producing three octahedron-shaped seed crystals (H,T1,T2) by sawing out of a conventional ⟨110⟩oriented monocrystal, in such a way that all the octahedron surfaces with ⟨111⟩crystal planes are identical,
- connecting two of the seed crystals (H,T1) by laying them on one another and fixing with a wire, in such a way that a twin crystal boundary of the first order is formed,
- with the aid of the two connected seed crystals (H,T1), a bicrystal (BS) is grown by means of a crystal-pulling process,
- from the bicrystal (BS), a wedge-shaped piece (K) is sawn out and in this process a ⟨111⟩ plane exposed respectively from the two half-crystals,
- the third seed crystal (T2) is so inserted into the wedge-shaped gap that it forms with the ⟨111⟩ crystal surface a second twin crystal boundary of the first order,
- the bicrystal (BS) is shortened approximately to the length of the third seed crystal (T2), to form a tricrystal seed,
- with the aid of the tricrystal seed, a tricrystal rod is pulled from a silicon melt (4) by means of a crystal-pulling process,
- from the tricrystal rod, semiconductor wafers are sawn out by means of a wire saw.

**9.** Method according to claim 8,
wherein a molybdenum wire is used to fix the seed crystals (H,T1,T2).

**10.** Method according to claim 8 or 9,
wherein a Czochralski process is used for the crystal pulling.

**11.** Method according to one of claims 8 to 10,
wherein the tricrystal seed and the growing tricrystal rod are so aligned that six mirror-similar facets are formed on the tricrystal rod.

**12.** Method according to one of claims 8 to 11,
wherein, after the pulling of a first tricrystal rod from a quartz crucible, the silicon melt, used up to a maximum of a third, is replenished by the addition of fresh silicon and the whole procedure is repeated up to ten times.

**13.** Method according to claim 12,
wherein the sawn-off point of a previously pulled tricrystal rod is used as the seed crystal.

**Revendications**

**1.** Cellule solaire constituée d'une plaquette à semi-conducteur mécaniquement stable, d'une épaisseur de 60 à 90 μm, faisant office de substrat, composée de trois zones (6, 7, 8) monocristallines, inclinées les unes par rapport aux autres, constituant trois secteurs de cercles, dont les lignes et les surfaces limites s'étendent radialement, les unes par rapport aux autres et constituent des angles (W6, W7, W8) inférieurs à 180°, deux des surfaces limites étant des limites de grains jumeaux de premier ordre entre chaque fois deux plans de cristaux ⟨111⟩ avec

- un léger dopage p dans la plaquette (11),
- un émetteur (16) plat, dopé n$^+$ sur une profondeur de 0,2-2 μm, sur une face avant,
- une première couche de passivation (15) sur la face avant,
- une deuxième couche de passivation (19) ou une back surface field sur la face arrière, et
- des contacts dérivation de courant (13, 18) sur la face avant et la face arrière.

**2.** Cellule solaire selon la revendication 1, caractérisée en ce que le silicium est un silicium (Cz-Si) étiré en creuset, le rendement de la cellule solaire étant supérieur à 20 %.

**3.** Cellule solaire selon la revendication 1 ou 2, dans laquelle les surfaces limites sont placées à peu près perpendiculairement par rapport au plan de la plaquette et constituent les unes par rapport aux autres les angles W6, W7 et W8, sachant que :

W7 = W8 = (360° - W6)/2 et W6 = 109,47 ± 2°.

**4.** Cellule solaire selon l'une des revendications 1 à 3, dans laquelle les surfaces des trois zones monocristallines (6, 7, 8) sont des plans cristallins ⟨110⟩

**5.** Cellule solaire selon l'une des revendications 1 à 4, ayant en face avant une texturation se présentant sous la forme de cônes (12) gravés dans la surface de semi-conducteur.

**6.** Cellule solaire selon l'une des revendications 1 à 5, dans laquelle la première couche de passivation (15) placée en face avant est une couche d'oxyde donnant une vitesse de combinaison de porteurs de charges $S_r$ sur la surface inférieure à 1000 cm/s.

**7.** Cellule solaire selon l'une des revendications 1 à 6, dans laquelle la surface arrière a une vitesse de combinaison de porteurs de charges $S_r$ inférieure à 100 cm/s

**8.** Procédé de fabrication d'une plaquette à semi-conducteur en silicium pour un substrat pour cellule solaire ayant trois zones (6, 7, 8) monocristallines en forme de secteur de cercle, inclinées les unes par rapport aux autres, comportant les étapes consistant à

- fabriquer trois cristaux de germe (H, T1, T2) à forme octaédrique, par extraction par sciage à partir d'un monocristal classique orienté ⟨110⟩ de manière que l'ensemble des surfaces octaédriques soit identique, avec des plans cristallins ⟨111⟩
- liaison de deux des cristaux de germe (H, T1) par application l'un sur l'autre et fixation avec un fil, de manière à constituer une limite de grains jumeaux de premier ordre,
- culture d'un bi-cristal (BS) à l'aide des deux cristaux de germe (H, T1) reliés, au moyen d'un procédé de culture de cristal,
- extraction par sciage, à partir du bi-cristal (BS), d'un élément cunéiforme (K) et dégagement alors, à partir de deux semi-cristaux, chaque fois d'un plan ⟨111⟩
- le troisième cristal de germe (T2) est inséré dans l'interstice cunéiforme, de manière à constituer avec la face cristalline ⟨111⟩ une deuxième limite de grains jumeaux de premier ordre,
- le bi-cristal (BS) est raccourci à peu près à la longueur du troisième cristal de germe (T2) pour constituer un inoculat tri-cristallin,
- une barre tri-cristalline est étirée à partir d'une masse de silicium (4) en fusion, à l'aide de l'inoculat tri-cristallin et au moyen d'un procédé de culture de cristaux,
- des plaquettes à semi-conducteur sont découpées par sciage avec une scie à fil à partir de la barre tri-cristalline.

**9.** Procédé selon la revendication 8,
dans lequel un fil de molybdène est utilisé pour fixer les cristaux de germe (H, T1, T2).

**10.** Procédé selon la revendication 8 ou 9,
dans lequel un procédé de Czochralski est utilisé pour la culture des cristaux.

**11.** Procédé selon l'une des revendications 8 à 10,

dans lequel l'inoculat tri-cristallin et la barre tri-cristalline en croissance sont orientés de manière que se constituent sur la barre tri-cristalline six facettes analogues à des miroirs.

12. Procédé selon l'une des revendications 8 à 11, dans lequel, après étirage d'une première barre tri-cristalline à partir d'un creuset de fusion en quartz, la masse en fusion de silicium, qui au maximum a été consommée pour un tiers, est rechargée par addition de silicium neuf et l'ensemble du processus étant répété jusqu'à 10 fois.

13. Procédé selon la revendication 12, dans lequel on utilise comme cristal de germe la pointe sciée d'une barre tri-cristalline précédemment étirée.

FIG 1

FIG 5

FIG 2

FIG 6

FIG 3

FIG 4

FIG 7

FIG 8

FIG 9

FIG 10